# EUROPÄISCHE PATENTSCHRIFT

(11) **EP 3 696 817 B1**
(45) Veröffentlichungstag und Bekanntmachung des Hinweises auf die Patenterteilung: **30.03.2022**
(21) Anmeldenummer: 19157721.2
(22) Anmeldetag: 18.02.2019
(51) Int. Cl.: G11C 5/14, G01F 23/284

(54) **RADARSENSOR MIT EINER KOMMUNIKATIONSSCHNITTSTELLE**
RADAR SENSOR HAVING A COMMUNICATION INTERFACE
CAPTEUR RADAR DOTÉ D'UNE INTERFACE DE COMMUNICATION

(43) Veröffentlichungstag der Anmeldung: 19.08.2020
(73) Patentinhaber: VEGA Grieshaber KG, 77709 Wolfach (DE)
(72) Erfinder: Weinzierle, Christian, 77709 Wolfach - Kirnbach (DE); Welle, Roland, 77756 Hausach (DE); Schultheiss, Daniel, 78132 Hornberg (DE); Dieterle, Levin, 77709 Oberwolfach (DE)
(74) Vertreter: Patentanwälte Bauer Vorberg Kayser

(56) Entgegenhaltungen:
- US-A1- 2018 348 038
- Ifm Electronic: "Operating instructions Electronic level sensor Contents", , 31. Juli 2015 (2015-07-31), XP055598562, Gefunden im Internet: URL:https://www.ifm.com/mounting/80230928U K.pdf [gefunden am 2019-06-21]
- Technologie Und Anwendung: "IO-Link Systembeschreibung", , 31. Dezember 2018 (2018-12-31), XP55598678, Gefunden im Internet: URL:https://io-link.com/share/Downloads/At -a-glance/IO-Link_Systembeschreibung_dt_20 18.pdf [gefunden am 2019-06-24]

## Beschreibung

Die vorliegende Erfindung betrifft einen Radarsensor mit einer Kommunikationsschnittstelle gemäß dem Oberbegriff des Patentanspruchs 1.

Aus dem Stand der Technik sind Radarsensoren grundsätzlich bekannt und bspw. im Bereich der Prozessautomatisierung weit verbreitet. Füllstandmessgeräte auf Basis von Radar haben aufgrund vielfältiger Vorteile der Radarmesstechnik in den vergangenen Jahren im Bereich der Prozessautomatisierung eine große Verbreitung gefunden.

Unter dem Begriff Automatisierungstechnik wird ein Teilgebiet der Technik verstanden, welche alle Maßnahmen zum Betrieb von Maschinen und Anlagen ohne Mitwirkung des Menschen beinhaltet, so kann das Teilgebiet der Prozessautomatisierung als niedrigster Grad der Automatisierung verstanden werden. Ziel der Prozessautomatisierung ist es, das Zusammenspiel einzelner Komponenten einer Werksanlage in den Bereichen Chemie, Erdöl, Papier, Zement, Schifffahrt oder Bergbau zu automatisieren. Hierzu sind eine Vielzahl an Sensoren bekannt, welche insbesondere an die spezifischen Anforderungen der Prozessindustrie, wie bspw. mechanische Stabilität, Unempfindlichkeit gegenüber Verschmutzung, extremen Temperaturen und extremen Drücken, angepasst sind. Messwerte dieser Sensoren werden üblicherweise an eine Leitwarte übermittelt, in welcher Prozessparameter wie Füllstand, Durchfluss, Druck oder Dichte überwacht und Einstellungen für die gesamte Werksanlage manuell oder automatisiert verändert werden können.

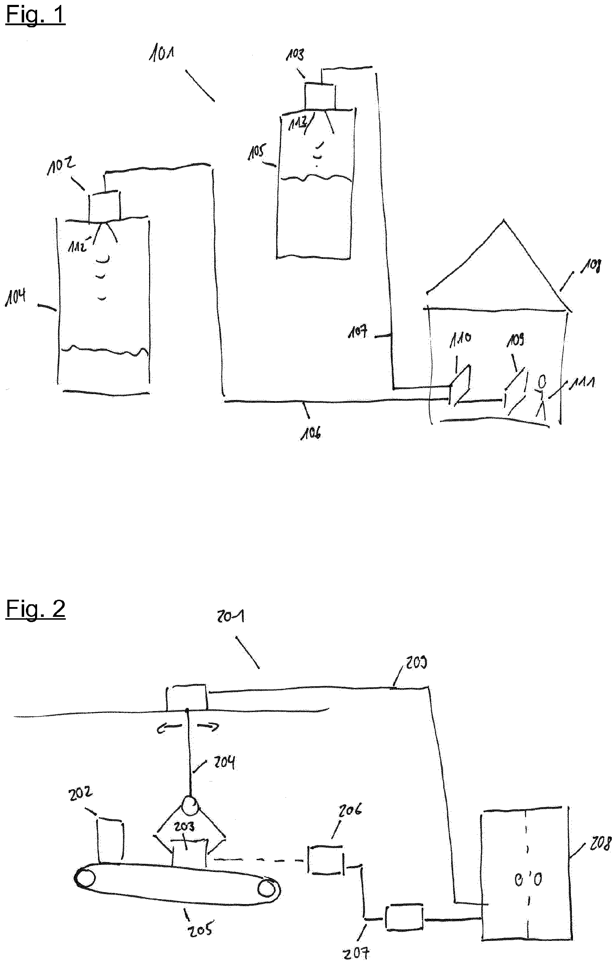

Figur 1 zeigt ein Beispiel einer solchen Anlage 101.

In Figur 1 sind exemplarisch zwei Prozessmessgeräte 102, 103 dargestellt, die unter Verwendung von Radarstrahlung den Füllstand von zwei Behältern 104, 105 erfassen. Die erfassten Messwerte werden unter Verwendung von speziellen Kommunikationsverbindungen 106, 107 an eine Leitwarte 108 übermittelt. Für die Übermittlung der Messwerte über die Kommunikationsverbindungen 106, 107 werden sowohl drahtgebundene als auch drahtlose Kommunikationsstandards verwendet, die auf die spezifischen Anforderungen der Prozessmesstechnik hin optimiert wurden. Typische Anforderungen an solche Kommunikationsverbindungen sind bspw. eine Robustheit der Signalübertragung gegenüber Störungen, eine Übertragung über große Distanzen, eine niedrige Datenraten, sowie häufig eine niedrige Energiedichte aufgrund Anforderungen des Explosionsschutzes.

Die Prozessmessgeräte 102, 103 beinhalten aus diesem Grund zumindest eine Kommunikationseinheit zur Unterstützung prozessindustrietauglicher Kommunikationsstandards. Beispiele für solche Kommunikationsstandards sind rein analoge Standards wie die 4 bis 20 mA Schnittstelle oder aber auch digitale Standards wie HART, Wireless HART oder PROFIBUS.

In der Leitwarte 108 werden die ankommenden Daten von einem Prozessleitsystem 110 verarbeitet und auf einem Monitoring-System 109 visuell dargestellt. Das Prozessleitsystem 110 oder aber auch ein Benutzer 111 kann auf Basis der Daten Veränderungen von Einstellungen vornehmen, die den Betrieb der ganzen Anlage 101 optimieren können. In einem einfachen Fall wird bspw. bei drohendem Leerlauf eines Behälters 104, 105 ein Belieferungsauftrag bei einem externen Lieferanten ausgelöst. Da die Kosten für die Prozesssensoren 102, 103 im Bereich der Prozessindustrie im Vergleich zu der gesamten Anlage 101 von untergeordneter Bedeutung sind, können zur optimalen Umsetzung der Anforderungen wie Temperaturbeständigkeit oder auch mechanischer Robustheit höhere Kosten in Kauf genommen werden. Die Prozesssensoren 102, 103 verfügen daher über preisintensive Komponenten wie bspw. Radarantennen 112 aus Edelstahl. Der übliche Preis eines solchen Prozesssensors 102, 103 liegt daher üblicherweise im Bereich von mehreren tausend Euro. Die bislang bekannten radarbasierten Proszesssensoren 102, 103 der Prozessindustrie verwenden zur Messung Radarsignale im Bereich von 6 GHz, 24 GHz oder auch 80 GHz, wobei die Radarsignale nach dem FMCW-Verfahren im Bereich der eben genannten Frequenzen frequenzmoduliert werden.

Ein anderes Teilgebiet der Automatisierungstechnik betrifft die Logistikautomation. Mit Hilfe von Distanz- und Winkelsensoren werden im Bereich der Logistikautomation Abläufe innerhalb eines Gebäudes oder innerhalb einer einzelnen Logistikanlage automatisiert. Typische Anwendungen finden Systeme zur Logistikautomation im Bereich der Gepäck- und Frachtabfertigung an Flughäfen, im Bereich der Verkehrsüberwachung (Mautsysteme), im Handel, der Paketdistribution oder aber auch im Bereich der Gebäudesicherung (Zutrittskontrolle). Gemein ist den zuvor aufgezählten Beispielen, dass eine Präsenzerkennung in Kombination mit einer genauen Vermessung der Größe und der Lage eines Objektes von der jeweiligen Anwendungsseite gefordert wird. Bekannte Radarsysteme sind bislang nicht in der Lage, die Anforderungen hierbei zu erfüllen, weshalb im bekannten Stand der Technik unterschiedliche Sensoren auf Basis optischer Messverfahren mittels Laser, LED, 2D-Kameras oder 3D-Kameras, die nach dem Laufzeitprinzip (time off light, ToF) Abstände erfassen, verwendet werden.

Figur 2 zeigt ein Beispiel einer Anlage der Logistikautomation.

Innerhalb einer Paketsortieranlage 201 sollen Pakete 202, 203 mit Hilfe eines Sortierkrans 204 sortiert werden. Die Pakete laufen hierbei auf einem Förderband 205 in die Sortieranlage ein. Mit Hilfe eines oder mehrerer Lasersensoren 206 und/oder Kamerasensoren 206 wird sowohl die Lage als auch die Größe des Paketes 203 berührungslos ermittelt und mit Hilfe schneller Datenleitungen 207 an eine Steuerung 208, beispielsweise einer SPS übermittelt, welche üblicherweise Teil der Anlage 201 ist. Da die Übermittlung der Messwerte über die Leitungen 207 zeitkritisch ist, die zu überbrückenden Distanzen aber eher im Bereich weniger Meter liegen, kommen als Übertragungsstandards auf den Kommunikationskanälen 207 üblicherweise schnelle digitale Protokolle wie Profinet, Ethercat oder IO-Link zum Einsatz, welche im Gegensatz zu den bekannten Protokollen der Prozessautomatisierung eine Echtzeitfähigkeit aufweisen, d.h. eine garantierte Übermittlung der Daten in einer vorgebbaren Zeit. Diese Echtzeitfähigkeit der Datenübermittlung, welche sowohl mit drahtgebundenen als auch mit drahtlosen Kommunikationsstandards erreicht werden kann, ist Grundlage für die Steuerung des Sortierkrans 204 über eine Steuerleitung 209. Im Gegensatz zu bekannten Radarmessgeräten ermöglichen optische Sensoren 206 eine exakte Bestimmung der Größe und Lage eines Objektes 203, da der Aufbau miniaturisierter Sensoren mit extrem kleinem Stahlöffnungswinkel im Bereich der Optik technisch kein Problem darstellt. Darüber hinaus können solche Systeme im Vergleich zu Prozessmessgeräten auch sehr preisgünstig hergestellt werden.

Ein drittes Teilgebiet der Automatisierungstechnik betrifft die Fabrikautomation. Anwendungsfälle hierzu finden sich in den unterschiedlichsten Branchen wie Automobilherstellung, Nahrungsmittelherstellung, Pharmaindustrie oder allgemein im Bereich der Verpackung. Ziel der Fabrikautomation ist, die Herstellung von Gütern durch Maschinen, Fertigungslinien und/oder Roboter zu automatisieren, d.h. ohne Mitwirkung des Menschen ablaufen zu lassen. Die hierbei verwendeten Sensoren und spezifischen Anforderungen im Hinblick auf die Messgenauigkeit bei der Erfassung der Lage und Größe eines Objektes sind mit denen der im vorigen Beispiel der Logistikautomation vergleichbar. Üblicherweise werden daher auch im Bereich der Fabrikautomation im großen Stil Sensoren auf Basis optischer Messverfahren eingesetzt.

Sowohl im Bereich der Logistikautomation, als auch im Bereich der Fabrikautomation und der Sicherheitstechnik dominieren bislang optische Sensoren. Diese sind schnell und preisgünstig und können die Lage und/oder den Abstand zu einem Objekt aufgrund der relativ einfach fokussierbaren optischen Strahlung, welche der Messung zu Grunde liegt, zuverlässig ermitteln. Ein bedeutender Nachteil optischer Sensoren ist aber deren erhöhter Wartungsbedarf, da auch in den zuvor aufgezählten Bereichen nach einigen tausend Betriebsstunden ein Verschmutzen des Sensors zu beobachten ist, welche die Messung massiv beeinträchtigt. Zudem kann speziell beim Einsatz in Fertigungslinien die Messung durch Öldämpfe oder andere Aerosole mit Nebelbildung beeinträchtigt werden, und zu einer zusätzlichen Verschmutzung optischer Sensoren führen.

Aus lfm Electronic: "Operating instructions Electronic level sensor Contents", 31. Juli 2015 (2015-07-31), XPO55598562, https://www.ifm.com/mounting/80230928UK.pdf [aufgerufen am 2019-06-21] ist ein Sensor mit einem geführten Radar bekannt. Der Sensor weist eine IO-Link Schnittstelle auf.

Aus Technologie Und Anwendung: "IO-Link Systembeschreibung", 31. Dezember 2018 (2018-12-31), XP55598678, URL:https:/fio-link.com/share/Downloads/Ata-glance/IOLjnk_Systembeschreibung_dt_2o1 8.pdf [aufgerufen am 2019-06-24] ist der Zusammenhang zwischen einer single-drop Schnittstelle und einer IO-Schnittstelle beschrieben.

Aus US 2018/0348038 A1 ist ein Radarmessgerät bekannt, welches eine Antenne, eine Prozesseinheit, eine Kommunikationseinheit, sowie eine Energieversorgung in Form einer Batterie umfasst. Ferner kann auch ein Zwischenspeicher und ein Powermanagement-Schaltkreis vorgesehen sein. Es ist die Aufgabe der vorliegenden Erfindung, ein Radarmessgerät zur Verfügung zu stellen, das die Nachteile der optischen System überwindet, eine hohe Radarauflösung und eine sehr gute Strahlfokussierung in Verbindung mit einer echtzeitfähigen Kommunikationsschnittstelle in miniaturisierter Bauweise aufweist und zu einem moderaten Preis bereitgestellt werden kann.

Diese Aufgabe wird durch ein Radarmessgerät mit den Merkmalen des Patentanspruchs 1, ein Verfahren mit den Merkmalen des Patentanspruchs 6 sowie die Verwendung eines Radarmessgeräts gemäß Patentanspruch 9 gelöst. Vorteilhafte Weiterbildungen sind Gegenstand abhängiger Patentansprüche.

Ein erfindungsgemäßes Radarmessgerät zur Fabrik und/oder Logistikautomation mit einer Versorgungseinheit zur Versorgung nachgeschalteter Einheiten mit Energie, einer Kommunikationseinheit zum Empfangen von Daten einer übergeordneten Einheit und zur Übertagung von Daten des Messgeräts an die übergeordnete Einheit, einer Auswerte- und Steuereinheit zur Steuerung einer nachgeschalteten Hochfrequenzeinheit und zur Auswertung von Messdaten die von der Hochfrequenzeinheit ermittelt wurden, zeichnet sich dadurch aus, dass die Kommunikationseinheit als single-drop-Schnittstelle ausgebildet ist. Die Versorgungseinheit ist in die Kommunikationseinheit integriert und das Radarmessgerät weist einen Energiezwischenspeicher auf.

Zur Erzielung einer noch kompakteren Bauform und möglichst geringer Herstellungskosten ist die Versorgungseinheit in die Kommunikationseinheit integriert. Durch den Einsatz standardmäßig erhältlicher IO-Link Bausteine mit integrierter Versorgungseinheit wird sichergestellt, dass günstige Komponenten verwendet werden können. Durch Verwendung dieser Standard-Komponenten, die weitgehend optimiert sind und in großen Stückzahlen produziert werden, kann neben einem günstigen Preis auch eine kompakte Bauform sichergestellt werden.

Da insbesondere die Hochfrequenzeinheit einen erhöhten Energiebedarf aufweist, der durch die in den Standard-Komponenten integrierte Versorgungseinrichtung im Dauerbetrieb nicht abgedeckt werden kann, weist die Radarmessanordnung einen Energiezwischenspeicher auf. Durch einen solchen Energiezwischenspeicher, bspw. einen passend dimensionierten Kondensator oder einen Akkumulator kann bspw. während der Auswertung einer Messung Energie für eine nachfolgende Messung zwischengespeichert und zum Messzeitpunkt zur Verfügung gestellt werden.

In einer bevorzugten Ausgestaltung kann die single-drop-Schnittstelle als IO-Link-Schnittstelle ausgebildet sein.

Mit dem Namen IO-Link ist ein Kommunikationssystem zur Anbindung intelligenter Sensoren und Aktoren an ein Automatisierungssystem in der Norm IEC 61131-9 (Stand 09/2013) unter der Bezeichnung Single-drop digital communication interface for small sensors and actuators (SDCI) normiert. Die Standardisierung umfasst dabei sowohl die elektrischen Anschlussdaten als auch ein digitales Kommunikationsprotokoll, über das die Sensoren und Aktoren mit dem Automatisierungssystem in Datenaustausch treten. Bei dem unter dem Namen IO-Link bekannten Kommunikationssystem handelt es sich um eine serielle, bidirektionale Punkt-zu-Punkt-Verbindung für eine Signalübertragung und Energieversorgung.

Ein IO-Link-System besteht aus einem IO-Link-Master und einem oder mehreren IO-Link-Geräten, also Sensoren oder Aktoren. Der IO-Link-Master stellt die Schnittstelle zu einer überlagerten Steuerung (SPS) zur Verfügung und steuert die Kommunikation mit den angeschlossenen IO-Link-Geräten.

Gemäß der vorliegenden Anmeldung wird eine Anbindung des Radarmessgeräts an den IO-Link-Master mit einem drei Leiter umfassenden Standard-Kabel bevorzugt.

Der Hochfrequenzeinheit gemäß der vorliegenden Anmeldung weist bevorzugt eine Messfrequenz von mehr als 50 GHz, vorzugweise von 80 GHz oder mehr auf. Durch Frequenzen in diesem Bereich kann eine sehr gute Strahlfokussierung erreicht werden, sodass präzise Messungen ermöglicht werden. Für die Fabrik- und Logistikautomatisierung werden Frequenzen von 100 GHz oder mehr bevorzugt. In konkreten Ausgestaltungsformen können Frequenzen von 120 GHz oder 240 GHz zum Einsatz kommen. Frequenzen oberhalb von 100 GHz ermöglichen zudem eine sehr kleine und kompakte Bauweise des gesamten Radarmessgeräts.

Um eine ungewollte Störung des vorliegenden Radarmessgeräts durch elektrische oder elektromagnetische Effekte anderer Geräte sowie eine Störung der anderen Geräte durch das vorliegende Radarmessgerät zu vermeiden, weist das Radarmessgerät der vorliegenden Anmeldung vorzugsweise eine Eingangsschaltung zur Sicherstellung der Elektromagnetischen Verträglichkeit auf.

Die in den Standard-Komponenten integrierten Versorgungseinrichtungen können eine maximale Leistung von ca. 100 mW, was für den Betrieb einer Hochfrequenzeinheit, bspw. zur Abstandsmessung nicht ausreichend ist. Derartige Hochfrequenzeinheiten haben eine Leistungsaufnahme von ca. 500mW, sodass zusätzliche Maßnahmen erforderlich sind um einen Betrieb zu gewährleisten.

Zusätzlich und/oder alternativ kann die Auswerte- und Steuereinheit des Radarmessgeräts eine Energiemanagementeinrichtung aufweisen. Durch ein entsprechende Energiemanagement kann z.B. die Hochfrequenzeinheit grundsätzlich in einem Energiesparmodus mit reduziertem Energiebedarf betrieben werden und nur bei Anforderung eines Messwerts, bspw. durch den IO-Link-Master aus dem Energiesparmodus in einen Messmodus überführt werden. Dies ist z.B. möglich, wenn die integrierte Versorgungseinheit den erhöhten Energiebedarf für eine Messung zwar kurzzeitig, jedoch nicht im Dauerbetrieb aufbringen kann.

In Kombination mit einem Energiezwischenspeicher kann auf diese Weise erreicht werden, dass die für eine Messung im Messmodus benötigte Energie schneller erreicht werden kann.

Unter einem Energiesparmodus soll in der vorliegenden Anmeldung ein Betriebszustand der Hochfrequenzeinheit mit gegenüber einem normalbetrieb reduziertem Energiebedarf verstanden werden. Ein Energiesparmodus umfasst insbesondere einen Standby-Betrieb und auch ein vollständiges deaktivieren. Auch andere Zustände mit reduzierter Energieaufnahme sollen erfasst sein, wobei immer eine Reduktion der Energieaufnahme gegenüber einem Normalbetrieb vorliegen muss. Das bedeutet insbesondere, dass ein Zustand im Normalbetrieb, in dem keine Messung erfolgt, nicht als Energiesparmodus verstanden werden soll.

Alternativ kann die Hochfrequenzeinheit anstatt nur auf Anforderung eine Messung auszuführen auch zyklisch, d.h. in regelmäßigen Zeitabständen aus dem Energiesparmodus in den Messmodus zur Durchführung einer Messung überführt werden. Selbstverständlich kann ein zyklischer Betrieb mit einem Betrieb auf Anforderung, wie er oben beschrieben wurde, kombiniert werden.

Ein erfindungsgemäßes Verfahren zum Betreiben eines Radarmessgeräts mit einer Versorgungseinheit zur Versorgung nachgeschalteter Einheiten mit Energie, einer Kommunikationseinheit zum Empfangen von Daten einer übergeordneten Einheit und zur Übertagung von Daten des Messgeräts an die übergeordnete Einheit, einer Auswerte- und Steuereinheit zur Steuerung einer nachgeschalteten Hochfrequenzeinheit und zur Auswertung von Messdaten, die von der Hochfrequenzeinheit ermittelt wurden, wobei die Kommunikationseinheit als singel-drop-Schnittstelle ausgebildet ist, zeichnet sich dadurch aus, dass die Hochfrequenzeinheit in einem Energiespar-Modus betrieben und auf Anforderung einer übergeordneten Einheit und/oder zyklisch zur Durchführung einer Messung aktiviert wird und nach Abschluss der Messung wieder in den Energiespar-Modus übergeht.

Wenn das Radarmessgerät einen Energiezwischenspeicher aufweist, kann die Hochfrequenzeinheit zumindest in dem Messmodus wenigstens teilweise über den Energiezwischenspeicher mit Energie versorgt werden. Auf diese Weise kann ein zusätzlicher Energiebedarf der Hochfrequenzeinheit zur Durchführung einer Messung über den Energiezwischenspeicher zur Verfügung gestellt werden. Während sich die Hochfrequenzeinheit in dem Energiesparmodus befindet, kann dann der Energiezwischenspeicher wieder aufgeladen werden.

Wenn die Auswerte- und Steuereinheit eine Energiemanagementeinrichtung aufweist, kann ein Energiemanagement, das bedeutet beispielsweise ein Aktivieren und Deaktivieren der Hochfrequenzeinheit oder eine Überführung der Hochfrequenzeinheit von einem Energiesparmodus in einen Messmodus und umgekehrt, durch die Energiemanagementeinrichtung vorgenommen werden. Zusätzlich zu der Hochfrequenzeinheit können auch weitere Komponenten des Radarmessgeräts durch das Energiemanagement erfasst sein.

Erfindungsgemäß wird das Radarmessgerät der vorliegenden Anmeldung in einem IO-Link Netzwerk verwendet. Es kann bspw. im Bereich der Fabrikautomation oder Logistikautomation zum Einsatz kommen.

Die vorliegende Erfindung wird nachfolgend anhand von Ausführungsbeispielen und unter Bezugnahme auf die beigefügten Figuren näher erläutert. Es zeigen:
- Figur 1: ein Beispiel einer Anlage der Prozessautomatisierung (schon behandelt)
- Figur 2: ein Beispiel einer Anlage der Logistikautomation (schon behandelt),
- Figur 3: ein Radarmessgerät,
- Figur 4: ein weiteres Radarmessgerät,
- Figur 5: eine Radarmessgerät gemäß der vorliegenden Anmeldung mit einem Energiezwischenspeicher und
- Figur 6: ein Ablaufdiagramm eines Verfahrens zum Betreiben des Radarmessgeräts gemäß Figur 5.

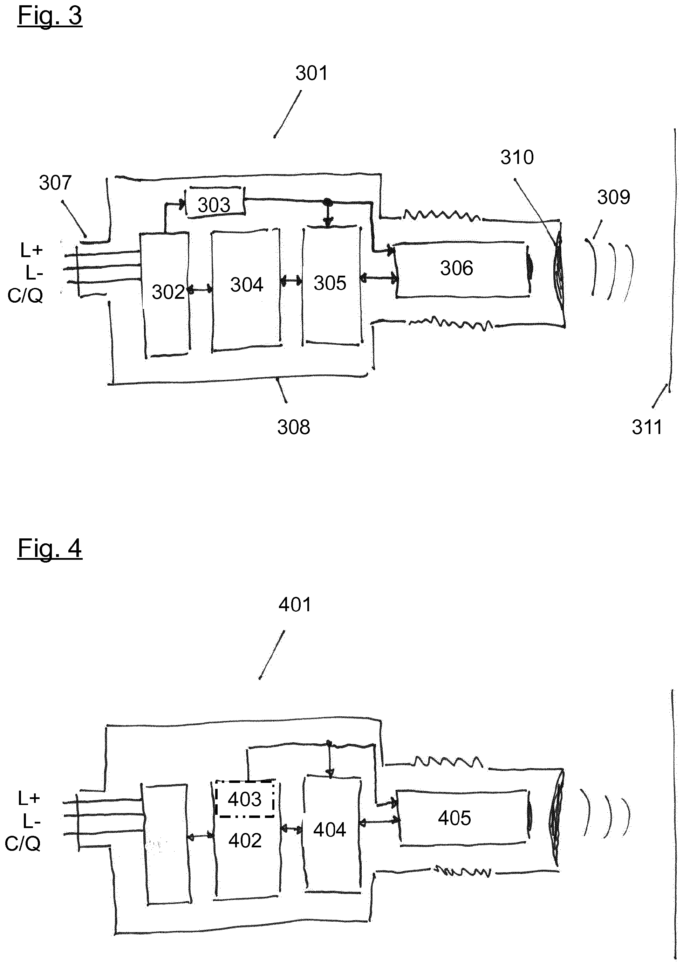

Figur 3 zeigt ein Radarmessgerät 301. Gezeigt ist der grundsätzliche Aufbau sowie die prinzipielle Funktionsweise eines Radarmessgeräts 301, das als 3-Leiter Radarmessgerät, welches für den Einsatz in der Fabrik- und oder Logistikautomation geeignet ist, ausgebildet ist.

Wesentliche Bestandteile des Radarmessgeräts 301 sind eine eingangsseitige EMV-Beschaltung 302, eine Kommunikationseinheit 304, die als digitale IO-Link-Schnittstelle ausgebildet ist, eine Auswerte- und Steuereinheit 305 sowie eine Hochfrequenzeinheit 306. Sowohl die Auswerte- und Steuereinheit 305 als auch die Hochfrequenzeinheit 306 sind über eine Versorgungseinheit 303, die der EMV-Eingangsschaltung 302 nachgeschaltet ist, mit Energie versorgt. Die Kommunikationseinheit 304 ist zur Kostenoptimierung als kommerziell erhältlich IO-Link Kommunikationseinheit ausgestaltet. Es ist eine Ausgestaltung mit einer 3-Leiter Schnittstelle vorgesehen, wobei die Anschlüsse L+ und L- zur Spannungsversorgung mit einer Nennspannung von 24V und der Anschluss C/Q als Daten Ein- und Ausgang ausgebildet ist.

Typisch für Anwendungen in der Fabrik- und Logistikautomation ist eine M12-Steckverbindung 307 für die Anschlussleitung sowie ein sehr kompaktes Sensorgehäuse 308. Vorteilhafterweise ist dieses aus Edelstahl gefertigt. Die Hochfrequenzeinheit 306 weist zumindest einen integrierten Radarchip auf, welcher hochfrequente Radarsignale 309 mit Frequenzen im Bereich von 80 GHz und mehr erzeugen und abstrahlen kann. Die Radarsignale 309 durchdringen das Gehäuse des Radarsensors 301 an einem Mikrowellenfenster 310, einer vordefinierten Stelle, wobei das Gehäuse des Sensors 301 zumindest im Bereich der Durchdringung für die erzeugten Radarsignale durchlässig ist. Insbesondere Frequenzen oberhalb von 100 GHz sind für Radarsysteme in der Fabrik- und Logistikautomation interessant. Die abgestrahlten elektromagnetischen Wellen werden an einem in Figur 3 beispielhaft dargestellten Objekt 311 reflektiert, von der Hochfrequenzeinheit 306 wieder empfangen und ausgewertet. Bspw. kann eine Entfernungs- und/oder Geschwindigkeitsinformation als Prozessinformation bestimmt werden, welche über die Steuer- und Auswerteeinheit 305 der IO-Link Kommunikationseinheit 304 zugeführt wird.

Mit Hilfe der IO-Link Kommunikationseinheit 304 können die Prozessinformationen an einen IO-Link Master bzw. an ein übergeordnetes Automatisierungssystem weitergegeben werden. Sowohl die Auswerte- und Steuereinheit 305 als auch die Hochfrequenzeinheit 306 werden von einer externen Versorgungseinheit 303 gespeist und mit Energie versorgt. Die separat ausgebildete Versorgungseinheit 303 ist vorliegend notwendig, da eine interne Versorgungseinheit der Kommunikationseinheit 304 keine ausreichende Leistung für den Betrieb der Auswerte- und Steuereinheit 305 und der Hochfrequenzeinheit 306 zur Verfügung stellt.

Figur 4 zeigt ein weiteres Radarmessgerät 401.

Zentraler Bestandteil dieses Sensors ist eine IO-Link Kommunikationseinheit 402 mit integriertem Netzteil 403. Durch die Integration ergibt sich der wesentliche Vorteil, dass die Auswerte- und Steuereinheit 404 sowie die Hochfrequenzeinheit 405 direkt von der Kommunikationseinheit 402 gespeist werden können. Die separate Versorgungseinheit 303 kann damit entfallen und es wird ein kompaktes, preisgünstiges sowie IO-Link fähiges Radarmessgerät 401 bereitgestellt. Die käuflich zu erwerbende Kommunikationseinheit 402 mit integriertem Netzteil 403 liefert aber nicht genügend Energie für die Versorgung der gesamten Schaltungskomponenten, d.h. insbesondere für die Auswerte- und Steuereinrichtung 404 und die Hochfrequenzeinheit 405. Insbesondere die Hochfrequenzeinheit 405 benötigt sehr viel Energie.

Um dennoch die Vorteile der Nutzung der integrierten Versorgungseinheit 403 realisieren zu können, ist in dem Radarmessgerät 401 gemäß Figur 4 ein intelligentes Powermanagement implementiert. Um mit der von der internen Versorgungseinheit 403 zur Verfügung gestellten Energie auszukommen, befindet sich die Hochfrequenzeinheit 405 in einem Energiesparmodus. Erst wenn von dem IO-Link Master ein aktueller Messwert angefordert und benötigt wird, wird die Hochfrequenzeinheit 405 für die Dauer einer Messung aktiviert und direkt nach der Messung wieder in den Energiesparmodus versetzt. Nur mit einem geeigneten Powermanagement ist es möglich die interne Versorgungseinheit 403 der Kommunikationseinheit 402 zu nutzen und folglich Platz sowie Kosten zu reduzieren.

Falls die von der internen Versorgungseinheit 403 zur Verfügung gestellte Energie im regulären Betrieb nicht für eine Messung der Hochfrequenzeinheit 405 ausreicht, kann zusätzlich eine Energiezwischenspeicher vorgesehen sein, der während sich die Hochfrequenzeinheit 405 im Energiesparmodus befindet, Energie speichert und zum Zeitpunkt einer Messung bereitstellt.

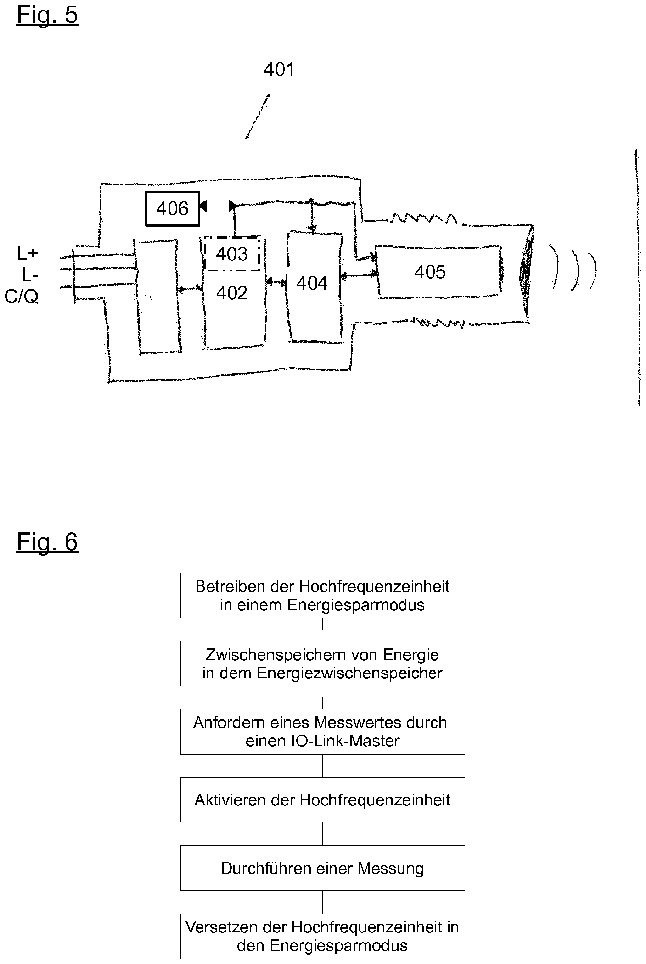

Figur 5 zeigt das Radarmessgerät gemäß Figur 4, wobei das Radarmessgerät zusätzlich einen Energiezwischenspeicher 406 aufweist, der einerseits mit der integrierten Versorgungseinheit 403 der IO-Link-Kommunikationseinheit 402 verbunden ist, und zum andern mit der Auswerte- und Steuereinrichtung 404 sowie der Hochfrequenzeinheit 405 verbunden ist. Zudem steht die Auswerte- und Steuereinrichtung 404 in Verbindung mit der Hochfrequenzeinheit 405. Der Energiezwischenspeicher ist im vorliegenden Ausführungsbeispiel als Kapazität ausgeführt, die während eines Energiesparmodus der Hochfrequenzeinheit 405 zusätzlich verfügbare Energie zwischenspeichert und diese der Hochfrequenzeinheit 405 zur Durchführung einer Messung zur Verfügung stellt.

Figur 6 zeigt ein Ablaufdiagramm eines Verfahrens zum Betreiben des Radarmessgeräts 401 gemäß Figur 5. Die Hochfrequenzeinheit 405 wird zunächst in einem Energiesparmodus betrieben, das bedeutet, dass die Hochfrequenzeinheit gemäß dem vorliegenden Ausführungsbeispiel von der Auswerte- und Steuereinheit 404 deaktiviert ist. Während die Hochfrequenzeinheit 405 deaktiviert ist und aufgrund dessen keine Energie verbraucht, wird der Energiezwischenspeicher 406 durch die integrierte Versorgungseinheit 403 des IO-Link-Kommunikationsmoduls 402 geladen.

Wird seitens des IO-Link-Masters ein Messsignal angefordert, so wird die Hochfrequenzeinheit 405 aktiviert, d.h. aus dem Energiesparmodus in einen Betriebsmodus überführt. Es wird eine Messung durchgeführt, wofür die Hochfrequenzeinheit 405 zusätzlich zu der Energie aus der Versorgungseinheit 403 mit Energie aus dem Energiezwischenspeicher 406 versorgt wird. Auf diese Weise kann der erhöhte Energiebedarf der Hochfrequenzeinheit 405, der aus der Versorgungseinheit 403 alleine nicht gedeckt werden kann, dennoch aufgebracht werden.

Nach Abschluss der Messung wird die Hochfrequenzeinheit 405 wieder in den Energiesparmodus versetzt und der Energiezwischenspeicher 406 erneut aufgeladen, bis ein weiterer Messwert benötigt wird.

### Bezugszeichenliste

- 101: Anlage
- 102: Prozessmessgerät
- 103: Prozessmessgerät
- 104: Behälter
- 105: Behälter
- 106: spezielle Kommunikationsverbindung
- 107: spezielle Kommunikationsverbindung
- 108: Leitwarte
- 109: Monitoring-System
- 110: Prozessleitsystem
- 111: Benutzer
- 112: Radarantenne aus Edelstahl

- 201: Paketsortieranlage
- 202: Pakete
- 203: Pakete
- 204: Sortierkran
- 205: Förderband
- 206: Lasersensoren und/oder Kamerasensoren
- 207: Datenleitung
- 208: Steuerung
- 209: Steuerleitung

- 301: Radarmessgerät
- 302: Eingangsschaltung EMV-Beschaltung
- 303: Versorgungseinheit
- 304: Kommunikationseinheit
- 305: Auswerte- und Steuereinheit
- 306: Hochfrequenzeinheit
- 307: M12-Steckverbindung
- 308: Sensorgehäuse
- 309: Radarsignal
- 310: Mikrowellenfenster
- 311: Objekt

- 401: Radarmessgerät
- 402: IO-Link Kommunikationseinheit
- 403: Integriertes Netzteil
- 404: Auswerte- und Steuereinheit
- 405: Hochfrequenzeinheit
- 406: Energiezwischenspeicher

## Patentansprüche

1. Radarmessgerät (301, 401) zur Fabrik und/oder Logistikautomation mit einer Versorgungseinheit (303, 403) zur Versorgung nachgeschalteter Einheiten mit Energie,
einer Kommunikationseinheit (304, 402) zum Empfangen von Daten einer übergeordneten Einheit und zur Übertagung von Daten des Radarmessgeräts (301, 401) an die übergeordnete Einheit,
einer Auswerte- und Steuereinheit (305, 404) zur Steuerung einer nachgeschalteten Hochfrequenzeinheit (306, 405) und zur Auswertung von Messdaten, die von der Hochfrequenzeinheit (306, 405) ermittelt wurden, wobei die Kommunikationseinheit (304, 402) als single-drop-Schnittstelle ausgebildet ist
**dadurch gekennzeichnet, dass** die Versorgungseinheit (403) in die Kommunikationseinheit (402) integriert ist und das Radarmessgerät (301, 401) einen Energiezwischenspeicher (406) aufweist.

2. Radarmessgerät (301, 401) gemäß Patentanspruch 1,
**dadurch gekennzeichnet, dass**
die single-drop-Schnittstelle als IO-Link-Schnittstelle ausgebildet ist.

3. Radarmessgerät (301, 401) gemäß einem der vorhergehenden Patentansprüche,
**dadurch gekennzeichnet, dass**
die Hochfrequenzeinheit (306, 405) eine Messfrequenz von mehr als 50 GHz, vorzugweise mehr als 80 GHz, weiter bevorzugt von 100 GHz oder mehr aufweist.

4. Radarmessgerät (301, 401) gemäß einem der vorhergehenden Patentansprüche,
**dadurch gekennzeichnet, dass**
das Radarmessgerät (301, 401) eine Eingangsschaltung (302) zur Sicherstellung der Elektromagnetischen Verträglichkeit aufweist.

5. Radarmessgerät (301, 401) gemäß einem der vorhergehenden Patentansprüche,
**dadurch gekennzeichnet, dass**
die Auswerte- und Steuereinheit (305, 404) eine Energiemanagementeinrichtung aufweist.

6. Verfahren zum Betreiben eines Radarmessgeräts (301, 401) mit einer Versorgungseinheit (303, 403) zur Versorgung nachgeschalteter Einheiten mit Energie, einer Kommunikationseinheit (304, 402) zum Empfangen von Daten einer übergeordneten Einheit und zur Übertagung von Daten des Radarmessgeräts (301, 401) an die übergeordnete Einheit, einer Auswerte- und Steuereinheit (305, 404) zur Steuerung einer nachgeschalteten Hochfrequenzeinheit und zur Auswertung, von der Hochfrequenzeinheit (306, 405) ermittelten Messdaten, wobei die Kommunikationseinheit (304, 402) als single-drop-Schnittstelle ausgebildet ist, wobei die Versorgungseinheit (403) in die Kommunikationseinheit (402) integriert ist und das Radarmessgerät (301, 401) einen Energiezwischenspeicher (406) aufweist,
**dadurch gekennzeichnet, dass**
die Hochfrequenzeinheit (306, 405) in einem Energiespar-Modus betrieben und auf Anforderung einer übergeordneten Einheit und/oder zyklisch zur Durchführung einer Messung aktiviert wird und nach Abschluss der Messung wieder in den Energiespar-Modus übergeht.

7. Verfahren gemäß Patentanspruch 6,
**dadurch gekennzeichnet, dass**
das Radarmessgerät (401) einen Energiezwischenspeicher (406) aufweist, und die Hochfrequenzeinheit (405) wenigstens teilweise über den Energiezwischenspeicher (406) mit Energie versorgt wird.

8. Verfahren gemäß einem der Patentansprüche 6 oder 7,
**dadurch gekennzeichnet, dass**
die Auswerte- und Steuereinheit (404) eine Energiemanagementeinrichtung aufweist, die die Hochfrequenzeinheit (405) durch die
Energiemanagementeinrichtung aktiviert und deaktiviert.

9. Verwendung eines Radarmessgeräts (301, 401) gemäß einem der
Patentansprüche 1 bis 5 in einem IO-Link Netzwerk.

10. Verwendung gemäß Anspruch 9, in der Fabrikautomation oder
Logistikautomation.

## Claims

1. A radar measuring device (301, 401) for factory and/or logistics automation with
a supply unit (303, 403) for supplying downstream units with energy,
a communication unit (304, 402) for receiving data from a higher-level unit, and for transmitting data of the radar measuring device (301, 401) to the higher-level unit,
an evaluation and control unit (305, 404) for controlling a downstream high-frequency unit (306, 405), and for evaluating measurement data determined by the high-frequency unit (306, 405),
wherein the communication unit (304, 402) is configured as a single-drop interface,
**characterized in that**
the supply unit (403) is integrated into the communication unit (402), and the radar measuring device (301, 401) includes an intermediate energy storage device (406).

2. The radar measuring device (301, 401) according to patent claim 1, **characterized in that**
the single-drop interface is configured as an IO-Link interface.

3. The radar measuring device (301, 401) according to any one of the preceding patent claims,
**characterized in that**
the high-frequency unit (306, 405) has a measuring frequency of more than 50 GHz, preferably more than 80 GHz, more preferably of 100 GHz or more.

4. The radar measuring device (301, 401) according to any one of the preceding patent claims,
**characterized in that**
the radar measuring device (301, 401) comprises an input circuit (302) for ensuring electromagnetic compatibility.

5. The radar measuring device (301, 401) according to any one of the preceding patent claims,
**characterized in that**
the evaluation and control unit (305, 404) comprises an energy management device.

6. A method for operating a radar measuring device (301, 401) with a supply unit (303, 403) for supplying downstream units with energy, a communication unit (304, 402) for receiving data from a higher-level unit, and for transmitting data of the radar measuring device (301, 401) to the higher-level unit, an evaluation and control unit (305, 404) for controlling a downstream high-frequency unit, and for evaluating measurement data determined by the high-frequency unit (306, 405), wherein the communication unit (304, 402) is configured as a single-drop interface, wherein the supply unit (403) is integrated into the communication unit (402), and the radar measuring device (301, 401) includes an intermediate energy storage device (406),
**characterized in that**
the high-frequency unit (306, 405) is operated in an energy-saving mode and activated upon request from a higher-level unit and/or cyclically in order to perform a measurement, and returns to the energy-saving mode after the conclusion of the measurement.

7. The method according to patent claim 6,
**characterized in that**
the radar measuring device (401) includes an intermediate energy storage device (406), and
the high-frequency unit (405) is at least partially supplied with energy via the intermediate energy storage device (406).

8. The method according to any one of the patent claims 6 or 7,
**characterized in that**
the evaluation and control unit (404) comprises an energy management device, which activates and deactivates the high-frequency unit (405) by means of the energy management device.

9. Use of a radar measuring device (301, 401) according to any one of the patent claims 1 to 5 in an IO-Link network.

10. The use according to claim 9 in factory automation or logistics automation.

## Revendications

1. Appareil de mesure par radar (301, 401) pour l'automatisation de l'usine et/ou de la logistique, comprenant
une unité d'alimentation (303, 403) pour alimenter en énergie des unités montées en aval,
une unité de communication (304, 402) pour recevoir des données d'une unité supérieure et pour transmettre des données de l'appareil de mesure par radar (301, 401) à l'unité supérieure,
une unité d'évaluation et de commande (305, 404) pour commander une unité à haute fréquence (306, 405) montée en aval et pour évaluer des données de mesure qui ont été déterminées par l'unité à haute fréquence (306, 405), dans lequel l'unité de communication (304, 402) est conçue en tant qu'interface point à point,
**caractérisé par le fait que** l'unité d'alimentation (403) est intégrée à l'unité de communication (402) et que l'appareil de mesure par radar (301, 401) comprend un accumulateur d'énergie intermédiaire (406).

2. Appareil de mesure par radar (301, 401) selon la revendication 1, **caractérisé par le fait que** l'interface point à point est réalisée en tant qu'interface IO-Link.

3. Appareil de mesure par radar (301, 401) selon l'une quelconque des revendications précédentes, **caractérisé par le fait que** l'unité à haute fréquence (306, 405) présente une fréquence de mesure supérieure à 50 GHz, de préférence supérieure à 80 GHz, encore de préférence de 100 GHz ou plus.

4. Appareil de mesure par radar (301, 401) selon l'une quelconque des revendications précédentes, **caractérisé par le fait que** l'appareil de mesure par radar (301, 401) comprend un circuit d'entrée (302) pour assurer la compatibilité électromagnétique.

5. Appareil de mesure par radar (301, 401) selon l'une quelconque des revendications précédentes, **caractérisé par le fait que** l'unité d'évaluation et de commande (305, 404) comprend un dispositif de gestion d'énergie.

6. Procédé destiné à faire fonctionner un appareil de mesure par radar (301, 401) comprenant une unité d'alimentation (303, 403) pour alimenter en énergie des unités montées en aval, une unité de communication (304, 402) pour recevoir des données d'une unité supérieure et pour transmettre des données de l'appareil de mesure par radar (301, 401) à l'unité supérieure, une unité d'évaluation et de commande (305, 404) pour commander une unité à haute fréquence (306, 405) montée en aval et pour évaluer des données de mesure qui ont été déterminées par l'unité à haute fréquence (306, 405), dans lequel l'unité de communication (304, 402) est conçue en tant qu'interface point à point, dans lequel l'unité d'alimentation (403) est intégrée à l'unité de communication (402) et l'appareil de mesure par radar (301, 401) comprend un accumulateur d'énergie intermédiaire (406),
**caractérisé par le fait que**
l'unité à haute fréquence (306, 405) fonctionne en un mode d'économie d'énergie et est activée à la demande d'une unité supérieure et/ou de façon cyclique pour effectuer une mesure et repasse en mode d'économie d'énergie après que la mesure a été terminée.

7. Procédé selon la revendication 6, **caractérisé par le fait que** l'appareil de mesure par radar (401) comprend un accumulateur d'énergie intermédiaire (406), et l'unité à haute fréquence (405) est alimentée en énergie, au moins en partie, par l'intermédiaire de l'accumulateur d'énergie intermédiaire (406).

8. Procédé selon la revendication 6 ou 7, **caractérisé par le fait que** l'unité d'évaluation et de commande (404) comprend un dispositif de gestion d'énergie qui active et désactive l'unité à haute fréquence (405).

9. Utilisation d'un appareil de mesure par radar (301, 401) selon l'une
quelconque des revendications 1 à 5 dans un réseau IO-Link.

10. Utilisation selon la revendication 9 dans l'automatisation de l'usine ou
l'automatisation de la logistique.
